# EUROPÄISCHE PATENTANMELDUNG

(11) **EP 2 159 270 A1**
(43) Veröffentlichungstag der Anmeldung: **03.03.2010**
(21) Anmeldenummer: 08163205.1
(22) Anmeldetag: 28.08.2008
(51) Int. Cl.: C09D 11/00, H05K 3/12

(54) **Verfahren zur Herstellung von elektrisch leitfähigen Strukturen**

(71) Anmelder: Bayer MaterialScience AG, 51368 Leverkusen (DE)
(72) Erfinder: Jakob, Alexander, 08132 Mülsen OT Neuschönburg (DE); Lang, Heinrich Prof. Dr., 09125 Chemnitz-Harthau (DE); Baumann, Reinhard Prof., 82152 Krailling (DE); Jahn, Stephan, 09112 Chemnitz (DE); Reinhold, Ingo, 09405 Zschopau 14 (DE); Engisch, Lutz, 09387 Jahnsdorf (DE); Jenninger, Werner Dr., 50674 Köln (DE); Wagner, Joachim Dr., 51061 Köln (DE)

(57) **Zusammenfassung**

Die vorliegende Erfindung betrifft ein Verfahren zur Herstellung von elektrisch leitfähigen Strukturen, wobei eine Lösung eines Mctallcarboxylats der allgemeinen Formel (I)

[ Mⁿ⁺ ] [ ⁻OOC-CR¹R²-(O-CR³R⁴-CR⁵R⁶)_{Z}-O-CR⁷R⁸-CR⁹R¹⁰-X-R¹² ]ₙ (I)

mit: M = Cu, Ag, Au, Ni, Pd oder Pt
n = 1, 2 oder 3
R¹, R² = unabhängig voneinander H, Halogen, Alkyl oder Aryl
R³, R⁴, R⁵, R⁶, R⁷, R⁸, R⁹, R¹⁰ = unabhängig voneinander H, Methyl, F oder Trifluormethyl
z = 1, 2, 3, 4, 5, 6, 7, 8, 9, 10, 11 oder 12
X = O, S oder NR¹¹ mit R¹¹ = Alkyl, substituiertes Alkyl, Aryl oder substituiertes Aryl
R¹² = unfluoriertes, teilfluoriertes oder perfluoriertes Alkyl oder Aryl

in einem koordinierendem Lösungsmittel mittels Tintenstrahldrucken auf ein Substrat aufgetragen wird und mittels Energieeinwirkung das aufgetragene Metallcarboxylat (I) zumindest teilweise in das entsprechende Metall M überführt wird. Sie betrifft weiterhin gemäß diesem Verfahren erhaltene elektrisch leitfähige Strukturen und die Verwendung einer Lösung von (I) als Tinte für Tintenstrahldrucker.

## Beschreibung

Die vorliegende Erfindung betrifft ein Verfahren zur Herstellung von elektrisch leitfähigen Strukturen, wobei eine Lösung eines Metallcarboxylats in einem koordinierenden Lösungsmittel mittels Tintenstrahldrucken auf ein Substrat aufgetragen wird und danach das Metallcarboxylat mittels Energieeinwirkung zumindest teilweise in das entsprechende Metall überführt wird. Sie betrifft weiterhin mittels dieses Verfahrens erhaltene elektrisch leitfähige Strukturen und die Verwendung einer Lösung des Metallcarboxylats als Tinte für Tintenstrahldrucker.

Tintenstrahldruckverfahren (inkjet printing) und andere Druckverfahren können als alternative Möglichkeiten für das Auftragen von funktionellen Materialien in Betracht kommen. Der Vorteil an Tintenstrahldruckverfahren ist, dass das Druckbild, also letztendlich die fertigen Strukturen, jederzeit verändert werden kann. Im Siebdruckverfahren müsste erst eine neue Maske erstellt werden müssen. Ein wichtiger Bereich der gedruckten Elektronik betrifft leitfähige Strukturen aus Silber. Diese weisen eine hohe elektrische Leitfähigkeit und gleichzeitig eine verringerte Anfälligkeit für Korrosion aufgrund des edlen Charakters auf.

In der Verarbeitung von Silber oder anderen Metallen in einem fluiden Zustand existieren zwei grundlegende Konzepte. Einerseits können stabilisierte Nanopartikel in organischen Lösungsmitteln oder in Wasser dispergiert werden. Jedoch lässt sich feststellen, dass Partikel zu einer Verstopfung der Düsen im Tintenstrahldruckverfahren neigen, wenn ihr Durchmesser etwa 5% des Düsendurchmessers überschreitet. Weiterhin werden vergleichsweise hohe Temperaturen benötigt, um die stabilisierten Nanopartikel zu sintern. Dieses ist nicht mit allen Substraten verträglich.

Die zweite Möglichkeit ist die Verwendung einer Metalltinte, also einer Lösung eines metallhaltigen Moleküls in einem entsprechenden Lösungsmittel. Auch hier müssen aber die metallhaltigen Moleküle beispielsweise durch Zersetzung und anschließendes Sintern in das Metall überführt werden, was die Auswahl der Substrate einschränkt. So ist bei flexiblen Polymersubstraten die Sintertemperatur eine kritische Verfahrensgröße.

Pastenförmige Silbercarboxylatzubereitungen zur Herstellung von leitfähigen Strukturen werden in WO 2008/038976 offenbart. Diese Patentanmeldung betrifft einen organischen Silberkomplex, in welchem ein organischer Ligand, umfassend eine Aminogruppe und eine Hydroxylgruppe, an ein aliphatisches Silbercarboxylat mit einem Äquivalentverhältnis von 2:1 gebunden ist. Ebenfalls offenbart wird eine leitfähige Paste, umfassend eine Silberquelle aus Silberoxidpulver, Silberpulver und Silberflocken, sowie einen organischen Silberkomplex, in welchem ein organischer Ligand mit einer Aminogruppe und einer Hydroxylgruppe an den organischen Silberkomplex gebunden ist. Der organische Silberkomplex weist eine hohe Löslichkeit in Lösungsmitteln auf und liegt bei Raumtemperatur im flüssigen Zustand vor. Daher muss in einer leitfähigen Paste mit diesem Komplex ein zusätzliches Lösungsmittel nicht oder nur in geringen Mengen zugegen sein. Hierdurch kann der Silbergehalt erhöht werden. Weiterhin weist die leitfähige Paste mit dem Komplex eine hohe Viskosität auf, eine hohe Stabilität ohne zusätzliches Dispergiermittel und kann gleichzeitig einfach industriell verwendet werden. Jedoch können mit dieser leitfähigen Paste keine Strukturen mittels Tintenstrahldruckverfahren aufgebaut werden, so dass auf Siebdruckmethoden zurückgegriffen werden muss.

Andere Silbersalze als Silberquelle werden in US 5,491,059 offenbart. Hierbei handelt es sich um Silbercarboxylate, welche als die Silberquelle in einem schwarz/weiß thermographischen Element oder photothermographischen Element oder als Oxidationsmittel für eine farbstoffbasierte thermographische oder photothermographische Farbbildkonstruktion. Das Silbercarboxylat kann durch die nachfolgende allgemeine Formel dargestellt werden:

R³-X-(CH₂-CH₂-X)ₙ-L-CR¹R²-COO⁻ Ag⁺

wobei gilt:
R¹ und R² sind unabhängig voneinander Wasserstoff, Halogen, Alkyl, substituiertes Alkyl, aromatisch oder substituiert aromatisch;
R³ ist eine Alkylgruppe, eine Arylgruppe oder L-CR¹R²-COO⁻ Ag⁺;
L ist eine verbindende Gruppe, welche CR¹R² mit X verbindet;
X ist ausgewählt aus der Gruppe bestehend aus O, S und NR⁴, wobei R⁴ ausgewählt ist aus Alkyl, substituiertes Alkyl, aromatisch oder substituiert aromatisch; und
n ist eine ganze Zahl von 0 bis 12.

Diese Verbindungen werden in bildgewinnenden Prozessen eingesetzt, indem ein Substrat vollständig mit ihnen beschichtet wird und dann nach Belichtung ein latentes Bild entwickelt wird. Elektrisch leitfähige Strukturen sind nicht Gegenstand dieses Patents.

Wünschenswert wären folglich alternative Verfahren zur Darstellung einer Vielzahl von elektrisch leitfähigen Strukturen mittels Tintenstrahldruckverfahren.

Erfindungsgemäß vorgeschlagen wird daher ein Verfahren zur Herstellung von elektrisch leitfähigen Strukturen, wobei eine Lösung eines Metallcarboxylats der allgemeinen Formel (I)

[Mⁿ⁺][⁻OOC-CR¹R²-(O-CR³R⁴-CR⁵R⁶)_{z}-O-CR⁷R⁸-CR⁹R¹⁰-X-R¹²]ₙ (I)

mit: M = Cu, Ag, Au, Ni, Pd oder Pt
n = 1, 2 oder 3
R¹, R² = unabhängig voneinander H, Halogen, Alkyl oder Aryl
R³, R⁴, R⁵, R⁶, R⁷, R⁸, R⁹, R¹⁰ = unabhängig voneinander H, Methyl, F oder Trifluormethyl
z = 1, 2, 3, 4, 5, 6, 7, 8, 9, 10, 11 oder 12
X = O, S oder NR¹¹ mit R¹¹ = Alkyl, substituiertes Alkyl, Aryl oder substituiertes Aryl
R¹² = unfluoriertes, teilfluoriertes oder perfluoriertes Alkyl oder Aryl
in einem koordinierendem Lösungsmittel mittels Tintenstrahldrucken auf ein Substrat aufgetragen wird und mittels Energieeinwirkung das aufgetragene Metallcarboxylat (I) zumindest teilweise in das entsprechende Metall M überführt wird.

Elektrisch leitfähige Strukturen sind hierbei insbesondere Strukturen, welche eine Leitfähigkeit von mehr als 1 · 10⁶ S/m aufweisen.

Im Sinne der vorliegenden Erfindung haben die nachfolgenden Begriffe die Bedeutung:
Halogen: F, Cl, Br, I oder At.
Alkyl: lineares oder verzweigtes C₁ bis C₂₀-Alkyl, vorzugsweise Methyl, Ethyl, Propyl, iso-Propyl, tert-Butyl, Butyl oder Pentyl.
Substituiertes Alkyl: mit elektronenziehenden oder elektronenliefernden Substituenten substituierte Alkylgruppen gemäß der obigen Definition, wobei elektronenziehende Substituenten vorzugsweise Carbonylgruppen sind und elektronenliefernde Substituenten vorzugsweise Halogene sind.
Aryl: homo- oder hetero-Aromaten mit einem Molekulargewicht von ≤ 300, vorzugsweise Phenyl.
Substituiertes Aryl: mit elektronenziehenden oder elektronenliefernden Substituenten substituierte Arylgruppen gemäß der obigen Definition, wobei elektronenziehende Substituenten vorzugsweise Carbonylgruppen sind und elektronenliefernde Substituenten vorzugsweise Halogene sind.

Die Carbonsäuren in den Metallcarboxylatverbindungen können gemäß der allgemeinen Formel (I) unfluorierte Carbonsäuren mit Ethylenoxid- und/oder Propylenoxid-Bausteinen sein. Auch ist es möglich, dass teilfluorierte oder perfluorierte Carbonsäuren mit Ethylenoxid- und/oder Propylenoxid-Bausteinen eingesetzt werden.

Ein koordinierendes Lösungsmittel kann auch als Donorlösungsmittel oder Lewis-Base bezeichnet werden. Es ist in der Lage, polymere Aggregate der Metallcarboxylate (I) aufzubrechen, ohne dass zusätzliche Liganden zu den Metallcarboxylaten (I) hinzugefügt werden müssen.

Die Lösungen der Metallcarboxylate (I) weisen eine relativ geringe elektrische Leitfähigkeit auf, weswegen sie für den Einsatz in einem Tintenstrahldruckverfahren geeignet sind. Bei der Piezo-Technik im Druckkopf werden hohe elektrische Felder an die entsprechenden Kristalle angelegt.

Vorteilhafterweise ist die Lösung des Metallcarboxylats (I) partikelfrei. Dieses bedeutet, dass keine Partikel wie zum Beispiel Metallnanopartikel zusätzlich hinzugefügt wurden. So lassen sich Probleme mit verstopften Düsen an den Tintenstrahldruckköpfen vermeiden.

Erfindungsgemäß ist vorgesehen, dass die aufgetragene Lösung des Metallcarboxylats (I), gegebenenfalls nach einem Trocknungsschritt, mittels Energieeintrag in das entsprechende Metall überführt wird. Hierdurch werden dann die elektrisch leitfähigen Strukturen erhalten. Die Wahl der betreffenden Carbonsäure ist deswegen auch vorteilhaft, weil sie sich zu CO₂ und flüchtigen organischen Verbindungen zersetzen lässt.

Ein weiterer Vorteil des erfindungsgemäßen Verfahrens ist, dass gegenüber Metallnanopartikel-Tinten kostengünstigere Tinten als Metallquelle zum Einsatz kommen können. Das erfindungsgemäße Verfahren kann auch zur Herstellung von flexiblen und/oder transparenten elektrisch leitfähigen Strukturen eingesetzt werden.

In einer Ausführungsform des Verfahrens ist das Metallcarboxylat (I) so ausgewählt, dass gilt: M = Ag; n = 1; R¹, R², R³, R⁴, R⁵, R⁶, R⁷, R⁸, R⁹, R¹⁰ = H; z = 1; X = O; R¹² = Methyl. Folglich ergibt sich die Formel: [Ag⁺][⁻OOC-CH₂-O-CH₂-CH₂-O-CH₂-CH₂-O-CH₃]

Dieses Silbercarboxylat kann leicht aus der Reaktion von Silbernitrat mit der entsprechenden Carbonsäure unter Einsatz von Triethylamin als Base erhalten werden:

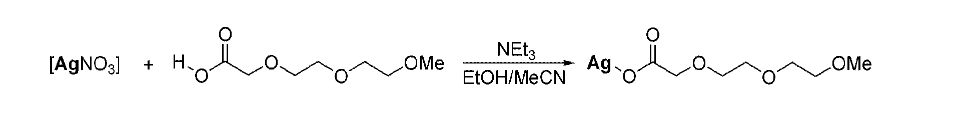

Im Gegensatz zum niedrigen Aggregationsgrad in Lösung liegt dieses Silbercarboxylat im Festkörper als Koordinationspolymer vor. Vorteilhaft an dieser Verbindung ist insbesondere, dass das Silbercarboxylat keine zusätzlichen Lewis-Basen benötigt, um in Lösung zu gehen. Koordinierende Lösungsmittel, insbesondere Wasser, sind hier ausreichend. Dieses Silbercarboxylat kann rückstandsfrei oder weitestgehend rückstandsfrei zu metallischen Silber umgesetzt werden.

In einer weiteren Ausführungsform des Verfahrens beträgt die Konzentration des Metallcarboxylats (I) in dem koordinierenden Lösungsmittel ≥ 1 Gewichts-% bis ≤ 30 Gewichts-%. Die Konzentration kann auch ≥ 21 Gewichts-% bis ≤ 24 Gewichts-% oder ≥ 22 Gewichts-% bis ≤ 23 Gewichts-% betragen. Solche Konzentrationen ermöglichen es, dass für den Tintenstrahldruck gut geeignete Tinten erhalten werden. Weiterhin lassen sich insbesondere bei niedrigen Konzentrationen flexible oder sogar transparente leitfähige Strukturen erhalten. Unabhängig davon kann die Tinte auch durch den Metallgehalt als solchem charakterisiert werden. So kann der Metallgehalt beispielsweise > 0,25 Gewichts-% bis ≤ 18 Gewichts-% oder ≥ 8 Gewichts-% bis ≤ 10 Gewichts-% ausmachen.

In einer weiteren Ausführungsform des Verfahrens beträgt die Viskosität der Lösung des Metallcarboxylats (I) ≥ 1 mPa s bis ≤ 100 mPa s. Die Viskosität kann anhand der Norm DIN 51562 Teil 1 bestimmt werden. Es ist einerseits möglich, dass sie beispielsweise in einem Bereich von ≥ 1,6 mPa s bis ≤ 1,9 mPa s oder von ≥ 1,7 mPa s bis ≤ 1,8 mPa s liegt. Es ist auch möglich, dass sie beispielsweise in einem Bereich von ≥ 5 mPa s bis ≤ 20 mPa s oder von ≥ 10 mPa s bis ≤ 12 mPa s liegt. Tinten mit solchen Viskositäten lassen sich gut in Tintenstrahldruckern verarbeiten. Die Viskosität kann beispielsweise über die Konzentration des Metallcarboxylats (I) eingestellt werden.

In einer weiteren Ausführungsform des Verfahrens beträgt die Oberflächenspannung der Lösung des Metallcarboxylats (I) ≥ 20 mN/m bis ≤ 70 mN/m. Die Oberflächenspannung kann anhand der Methode des hängenden Tropfens bestimmt werden. Hierfür eignet sich beispielsweise ein Kontaktwinkelmessgerät der Firma Dataphysics, Modell OCA 20. Es ist einerseits möglich, dass sie beispielsweise in einem Bereich von ≥ 57 mN/m bis ≤ 63 mN/m oder von ≥ 59 mN/m bis ≤ 60 mN/m liegt. Es ist auch möglich, dass sie beispielsweise in einem Bereich von ≥ 25 mN/m bis ≤ 35 mN/m oder von ≥ 28 mN/m bis ≤ 33 mN/m liegt. Tinten mit solchen Oberflächenspannungen lassen sich gut in Tintenstrahldruckern verarbeiten. Weiterhin lassen sich mit solchen Tinten auf polaren Substraten wie Glas, Polyimid oder Polyethylenterephthalat auch kleine Strukturen gut darstellen. Die Oberflächenspannung kann beispielsweise über die Konzentration des Metallcarboxylats (I) eingestellt werden.

In einer weiteren Ausführungsform des Verfahrens ist das koordinierende Lösungsmittel ausgewählt aus der Gruppe umfassend Wasser, Ethanol, Acetonitril, Tetrahydrofuran, Dioxan, Dimethylsulfoxid, aromatische Amine, Monoalkylamine, Dialkylamine, Trialkylamine, Monoalkanolamine, Dialkanolamine und/oder Trialkanolamine. Bevorzugt ist hierbei Wasser als Lösungsmittel, da es kostengünstig, nicht brennbar und gesundheitlich unbedenklich ist. Die vorgenannten Lösungsmittel weisen einen verhältnismäßig niedrigen Dampfdruck auf, so dass ein Verstopfen der Düse des Tintenstrahldruckkopfs durch Substanzreste nach dem Abdampfen des Lösungsmittels selten vorkommen und durch geeignete Spülzyklen schnell behoben werden können.

In einer weiteren Ausführungsform des Verfahrens wird beim Tintenstrahldrucken die Tropfenbildung in einem piezoelektrisch angetriebenen Druckkopf erreicht. Hierbei wird mit Hilfe des piezoelektrischen Effekts über die Wände der Tintendüse eine Schallwelle im Tintenvolumen der Druckdüse erzeugt, die an der Öffnung der Düse das Herausschleudern eines Tintentropfens in Richtung des Drucksubstrats verursacht. In Hinblick auf die thermische Stabilität der Funktionstinten liegt der Vorteil der Piezo-Köpfe im vergleichsweise milden Umgang mit den Tinten.

Einflussgrößen auf die Tropfenformation bei der Piezo-Technologie sind die Schallgeschwindigkeit in der Tinte selbst, die Grenzflächenspannungen zwischen den beteiligten Materialien und die Viskosität der Tinte. Darüber hinaus können über den zeitlichen Verlauf der an den Piezokristall angelegten Steuerspannung (Waveform) die Tropfengröße, -geschwindigkeit und -form und somit die Druckqualität beeinflusst werden. Angestrebt wird eine kugelförmige Tropfenform ohne Satellitentropfen. Tropfengröße und Tropfengeschwindigkeit bestimmen zusammen mit der Relativbewegung von Druckkopf zu Substrat Auflösung, Kantenschärfe und Druckgeschwindigkeit des Drucksystems.

Das Piezo-Inkjet Verfahren ist mit den beschriebenen Eigenschaften besonders geeignet für das Verdrucken von Tinten, mit Hilfe derer auf verschiedensten Substraten bildmäßig strukturierte Funktionsschichten erzeugt werden können. Es ergeben sich breite Variationsmöglichkeiten bei der Auswahl von Tintenbestandteilen und der Optimierung der Tropfenbildung. Damit erlaubt die Piezo-Technologie die weitaus größte Palette an Funktionsmaterialien zum gezielten strukturierten Abscheiden.

In einer weiteren Ausführungsform des Verfahrens wird der piezoelektrisch angetriebene Druckkopf mit einer Ansteuerspannung von ≥ 1 V bis ≤ 40 V und einer Pulsbreite von ≥ 1 µs bis ≤ 20 µs betrieben. Die Ansteuerspannung kann auch in einem Bereich von ≥ 10 V bis ≤ 20 V oder von ≥ 14 V bis ≤ 18 V liegen. Die Pulsbreite kann auch in einem Bereich von ≥ 3 µs bis ≤ 10 µs oder von ≥ 6 µs bis ≤ 7 µs liegen.

In einer weiteren Ausführungsform des Verfahrens umfasst das Substrat ein Material, welches ausgewählt ist aus der Gruppe umfassend Glas, Polyimid (PI), Polycarbonat (PC) und/oder Polyethylenterephthalat (PET). Diese Materialien lassen sich gut bedrucken und können leicht weiter funktionalisiert werden.

In einer weiteren Ausführungsform des Verfahrens beinhaltet die Energieeinwirkung ein Erhitzen auf ≥ 200 °C bis ≤ 250 °C. Diese Temperatur kann auch ≥ 210 °C bis ≤ 240 °C oder ≥ 220 °C bis ≤ 230 °C betragen. Bei diesen Temperaturen genügt es, für kurze Zeit zu erhitzen, um eine Umwandlung des Metallcarboxylats (I) zum Metall auszulösen. Vorteilhafterweise wird für ≥ 20 Sekunden bis ≤ 60 Sekunden oder von ≥ 30 Sekunden bis ≤ 50 Sekunden erhitzt.

In einer weiteren Ausführungsform des Verfahrens beinhaltet die Energieeinwirkung ein Bestrahlen mit Licht mit einer Wellenlänge von ≥ 325 nm bis ≤ 600 nm. Das eingestrahlte Licht kann in seiner Wellenlänge den Absorptionsmaxima der Metallcarboxylate weiter angepasst werden. So kann die Wellenlänge auch ≥ 310 nm bis ≤ 400 nm oder ≥ 330 nm bis ≤ 370 nm betragen und somit im UV-Bereich liegen. Durch photochemische Zersetzung des Metallcarboxylats (I) können leitfähige Strukturen auf solchen Substraten aufgebaut werden, welche eine thermische Zersetzung nicht vertragen. Die Dauer der Bestrahlung kann beispielsweise in einem Bereich von ≥ 10 Minuten bis ≤ 350 Minuten oder von ≥ 180 Minuten bis ≤ 300 Minuten liegen.

Vorteilhafterweise findet hierbei zusätzlich zum Bestrahlen mit Licht weiterhin eine Energieeinwirkung durch Erhitzen auf eine Temperatur von ≥ 100 °C bis ≤ 200 °C statt. Die Temperatur kann auch in einem Bereich von ≥ 120 °C bis ≤ 150 °C oder von ≥ 130 °C bis ≤ 140 °C liegen. Vorteilhaft am zusätzlichen Erwärmen während des Bestrahlens ist, dass eine schnellere Zersetzung des Metallcarboxylats (I) erreicht werden kann. Hierbei können synergistische Effekte genutzt werden, wobei das Bestrahlen mit Licht die thermische Zersetzung und den Abtransport der Zersetzungsprodukte unterstützt.

In einer weiteren Ausführungsform des Verfahrens wird das Tintenstrahldrucken so durchgeführt, dass der Abstand der Tropfen auf dem Substrat in einem Bereich von ≥ 15 µm bis ≤ 25 µm liegt und dass mindestens 2 Tropfenreihen nebeneinander gedruckt werden. Es können auch mehr Tropfenreihen nebeneinander gedruckt werden, beispielsweise 3, 4 oder 5. Der Tropfenabstand kann auch ein einem Bereich von ≥ 19 µm bis ≤ 21 µm liegen. Beim Drucken der Tropfenreihen nebeneinander überlappen sich die Tropfen, so dass breite Strukturen aufgebaut werden. Es können, abhängig von der gewünschten Breite der leitfähigen Struktur, natürlich auch mehr Tropfenreihen nebeneinander gedruckt werden. Die Breite einer Leiterbahn aus 5 nebeneinander liegenden Tropfenreihen kann beispielsweise ≥ 145 µm bis ≤ 155 µm betragen. Durch solch eine Drucksteuerung kann bei langen Strukturen, beispielsweise Leiterbahnen, verhindert werden, dass aufgrund von Verschmelzungen der Tintentröpfchen auf dem Substrat Bereiche ohne Verbindung zueinander auftreten.

Ein weiterer Gegenstand der Erfindung sind elektrisch leitfähige Strukturen, erhalten durch ein Verfahren gemäß der vorliegenden Erfindung. Solche elektrisch leitfähigen Strukturen können beispielsweise Leiterbahnen, Antennenelemente, Sensorelemente oder Bondverbindungen zum Kontaktieren mit Halbleiterbauelementen sein. In ihren Abmessungen können die Strukturen beispielsweise eine Breite von ≥ 150 µm bis ≤ 500 µm und eine Höhe von ≥ 100 nm bis ≤ 10 µm aufweisen.

Ein weiterer Gegenstand der Erfindung betrifft die Verwendung einer Lösung eines Metallcarboxylats der allgemeinen Formel (I)

[Mⁿ⁺][⁻OOC-CR¹R²-(O-CR³R⁴-CR⁵R⁶)_{z}-O-CR⁷R⁸-CR⁹R¹⁰-X-R¹²]ₙ (I)

mit: M = Cu, Ag, Au, Ni, Pd oder Pt
n = 1, 2 oder 3
R¹, R² = unabhängig voneinander H, Halogen, Alkyl oder Aryl
R³, R⁴, R⁵, R⁶, R⁷, R⁸, R⁹, R¹⁰ = unabhängig voneinander H, Methyl, F oder Trifluormethyl
z = 1, 2, 3, 4, 5, 6, 7, 8, 9, 10, 11 oder 12
X = O, S oder NR¹¹ mit R¹¹ = Alkyl, substituiertes Alkyl, Aryl oder substituiertes Aryl
R¹² = unfluoriertes, teilfluoriertes oder perfluoriertes Alkyl oder Aryl
in einem koordinierendem Lösungsmittel als Tinte für Tintenstrahldrucker.

Details zu den Substituenten, Resten, etc. und dem koordinierenden Lösungsmittel wurden bereits vorstehend beschrieben. Vorteilhafterweise umfasst das koordinierende Lösungsmittel Wasser oder ist Wasser.

Unabhängig davon ist vorteilhafterweise das das Metallcarboxylat (I) so ausgewählt, dass gilt: M = Ag; n = 1; R¹, R², R³, R⁴, R⁵, R⁶, R⁷, R⁸, R⁹, R¹⁰ = H; z = 1; X = O; R¹² = Methyl. Folglich ergibt sich die Formel: [Ag⁺][⁻OOC-CH₂-O-CH₂-CH₂-O-CH₂-CH₂-O-CH₃].

Die vorliegende Erfindung wird nachfolgend weiter anhand der Ausführungsbeispiele und unter Bezugnahme auf die Zeichnungen weiter erläutert. Zum leichteren Verständnis wird die Verbindung [Ag⁺ ] [ ⁻OOC-CH₂-O-CH₂-CH₂-O-CH₂-CH₂-O-CH₃ ] nachfolgend als Silbercarboxylat (II) bezeichnet.

Es zeigen hierbei:
- FIG. 1: eine thermogravimetrische Analyse des Silbercarboxylats (II)
- FIG. 2: ein DSC-Diagramm des Silbercarboxylats (II)
- FIG. 3: ein Profilometer-Bild eines getrockneten Tintentropfens mit dem Silbercarboxylat (II)
- FIG. 4: ein Profilometer-Bild eines gesinterten Tintentropfens mit dem Silbercarboxylat (II)
- FIG. 5: die Abhängigkeit der Leitfähigkeit von der Dauer der UV-Bestrahlung bei 135 °C für das Silbercarboxylat (II)

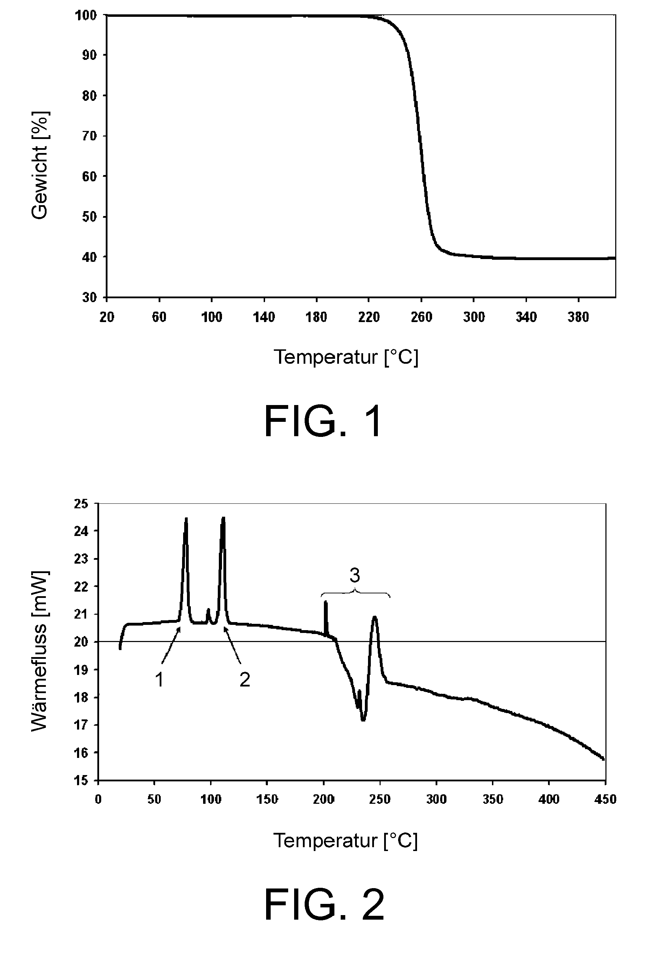

Zunächst wurde das Silbercarboxylat (II) charakterisiert. Die Ergebnisse sind in FIG. 1 und 2 wiedergegeben.

FIG. 1 zeigt eine thermogravimetrische Analyse (TGA) des Silbercarboxylats (II). Diese Analyse wurde durchgeführt, um dessen Zersetzungstemperatur bestimmen zu können. Die TGA wurde unter Stickstoffatmosphäre und Normaldruck durchgeführt. Weiterhin betrug die Heizrate 8 K/min und die Flussrate des Stickstoffs 20 dm³/h. Man erkennt, dass die thermische Zersetzung bei etwa 210 °C beginnt.

FIG. 2 zeigt ein Diagramm einer dynamischen Differenzkalorimetrischen Analyse (differential scanning calorimetry, DSC-Diagramm) des Silbercarboxylats (II). Die DSC-Analyse wurde unter Stickstoffatmosphäre und Normaldruck durchgeführt. Weiterhin betrug die Heizrate 8 K/min und die Flussrate des Stickstoffs 20 dm³/h. Man erkennt im Verlauf der Erwärmung der Probe zunächst einen endothermen Phasenübergang 1 sowie den endothermen Schmelzpunkt 2. Der exotherm/endotherm verlaufende Prozess 3 zeigt die Zersetzung des Carboxylatkomplexes und das Verdampfen von organischen Bestandteilen an.

Zur Herstellung von Strukturen mittels Tintenstrahldrucken wurde als Tinte eine Lösung von 23 Gewichts-% des Silbercarboxylats (II) in Wasser hergestellt. Umgerechnet entspricht das einem Silbergehalt von 9,1 Gewichts-%. Diese Lösung wies bei 20 °C eine Viskosität von 1,7 mPa s und eine Oberflächenspannung von 59,9 mN/m auf. Weiterhin war die Lösung partikelfrei. Mit den vorgenannten Charakteristika eignete sie sich für das piezoelektrische Tintenstrahldrucken.

Diese Tinte wurde in allen Beispielen in einem Dimatix Materials Printer DMP 2831 mit einem 10 pL-Druckkopf eingesetzt. Zur Steuerung wurde eine auf diese Tinte zugeschnittene Wellenform mit einer Maximalspannung von 16 V und einer Pulsbreite von 6,5 µs verwendet. Beim Drucken wurden weder der Druckkopf noch das Substrat beheizt. Mittels einer Stroboskopkamera wurde das Verhalten der Tröpfchen nach Austritt aus dem Druckkopf untersucht. Hierbei wurde beobachtet, dass nach 45 µs ein stabiles, sphärisches Tröpfchen gebildet wurde.

Zur Bestimmung der Haftung der erhaltenen Silberstrukturen auf dem Substrat wurden die Strukturen dreimal mit einem handelsüblichen Klebefilm der Marke Tesa beklebt und der Klebefilm nach einigen Sekunden wieder abgezogen. Der prozentuale Anteil der verbliebenen Fläche der Strukturen auf dem Substrat diente als Maß für die Haftung.

### Beispiel 1

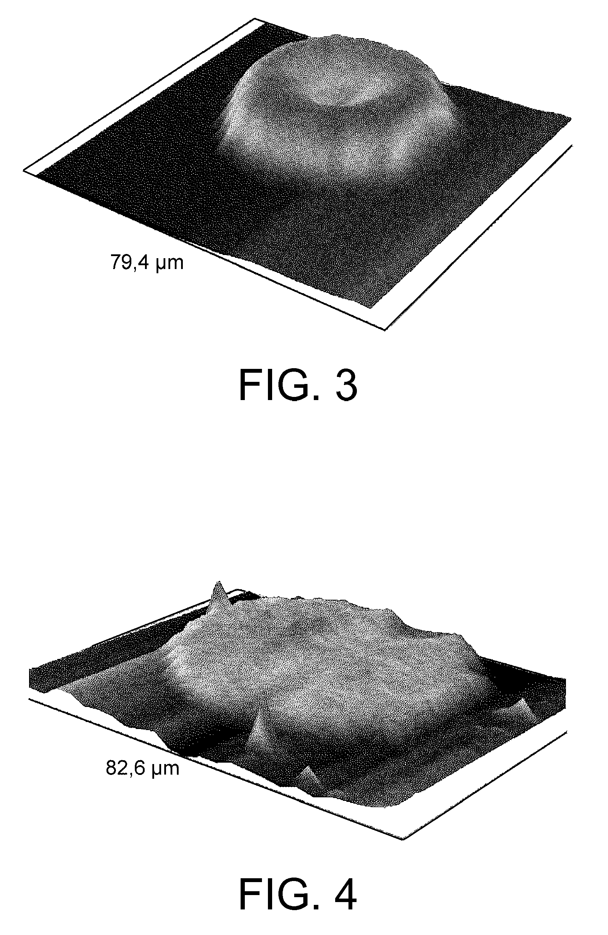

In diesem Beispiel wurde ein Tröpfchen der erfindungsgemäßen Tinte auf ein Glassubstrat gedruckt und getrocknet. Anschließend wurde für 30 Sekunden auf eine Temperatur von 220 °C erhitzt, so dass das Silbercarboxylat (II) zum Metall umgesetzt wurde. Profilmetrische Aufnahmen des getrockneten Tropfens sind in FIG. 3 und nach dem Sintern in FIG. 4 dargestellt. Das verwendete Gerät war ein taktiles Profilometer Veeco Dektak 8.

Der getrocknete Tropfen in FIG. 3 weist einen Durchmesser von etwa 50 µm auf und besitzt eine charakteristische ringförmige Gestalt. Diese Gestalt rührt von der Abscheidung von Material aufgrund der Verdunstung des Lösungsmittels her. Der Effekt, welcher zu dieser Gestalt führt, wird auch als "coffee ring effect" bezeichnet. Die Kantenlänge des in FIG. 3 abgebildeten Bereichs beträgt 79,4 µm.

Das Produkt der thermischen Umwandlung in FIG. 4 weist einen Durchmesser von etwa 63 µm auf und eine Höhe von etwa 100 nm. Gegenüber dem getrockneten, ungesinterten Tropfen fand also eine Verflachung und eine Verbreiterung ein. Die ringförmige Struktur ("coffee ring effect") lässt sich hier nicht mehr beobachten. Vielmehr befindet sich nun auch Material im Zentrum des gesinterten Tropfens und die Höhe der Struktur ist verhältnismäßig einheitlich.

### Beispiel 2

Ein Glassubstrat wurde erfindungsgemäß mit der bereits beschriebenen Tinte bedruckt. Hierbei wurde der Tröpfchenabstand auf dem Substrat auf 20 µm eingestellt, so dass geschlossene bedruckte Bereiche erhalten wurden. Nach dem Trocknen an der Luft wurde das bedruckte Substrat für 30 Sekunden auf eine Temperatur von 220 °C erhitzt. Die erhaltenen Silberstrukturen wiesen eine elektrische Leitfähigkeit von 19 · 10⁶ S/m auf. Verglichen mit der Leitfähigkeit von 67,1 · 10⁶ S/m für kompaktes Silber entspricht dieses 27,7% des Maximalwertes. Nach dem Klebefilm-Test waren noch 23,3% der ursprünglichen Fläche durch die Silberstrukturen auf dem Substrat bedeckt.

### Beispiel 3

Ein Polyimid- (PI-) Substrat wurde erfindungsgemäß mit der bereits beschriebenen Tinte bedruckt. Hierbei wurde der Tröpfchenabstand auf dem Substrat auf 20 µm eingestellt, so dass geschlossene bedruckte Bereiche erhalten wurden. Nach dem Trocknen an der Luft wurde das bedruckte Substrat für 30 Sekunden auf eine Temperatur von 220 °C erhitzt. Die erhaltenen Silberstrukturen wiesen eine elektrische Leitfähigkeit von 13 · 10⁶ S/m auf. Verglichen mit der Leitfähigkeit von 67,1 · 10⁶ S/m für kompaktes Silber entspricht dieses 19,3% des Maximalwertes. Nach dem Klebefilm-Test waren noch 98% der ursprünglichen Fläche durch die Silberstrukturen auf dem Substrat bedeckt.

### Beispiel 4

Ein Glassubstrat wurde erfindungsgemäß mit der bereits beschriebenen Tinte bedruckt. Hierbei wurde der Tröpfchenabstand auf dem Substrat auf 20 µm eingestellt, so dass geschlossene bedruckte Bereiche erhalten wurden. Nach dem Trocknen an der Luft wurde das bedruckte Substrat mit einer UV-Lampe vom Typ Delolux 06 (Emissionsspektrum: 325 bis 600 nm) bestrahlt, wobei der Abstand der Lampe zur Probe 20 cm betrug. Zusätzlich wurde die Probe auf eine Temperatur von 135 °C erhitzt. Nach einer Bestrahlungsdauer von 120 Minuten wiesen die erhaltenen Silberstrukturen eine Leitfähigkeit von 1,1 · 10⁶ S/m auf. Verglichen mit der Leitfähigkeit von 67,1 · 10⁶ S/m für kompaktes Silber entspricht dieses 16,6% des Maximalwertes.

### Beispiel 5

Ein Polyethylenterephthalat- (PET-) Substrat wurde erfindungsgemäß mit der bereits beschriebenen Tinte bedruckt. Hierbei wurde der Tröpfchenabstand auf dem Substrat auf 20 µm eingestellt, so dass geschlossene bedruckte Bereiche erhalten wurden. Nach dem Trocknen an der Luft wurde das bedruckte Substrat mit einer UV-Lampe vom Typ Delolux 06 (Emissionsspektrum: 325 bis 600 nm) bestrahlt, wobei der Abstand der Lampe zur Probe 20 cm betrug. Zusätzlich wurde die Probe auf eine Temperatur von 135 °C erhitzt. Nach einer Bestrahlungsdauer von 180 Minuten wiesen die erhaltenen Silberstrukturen eine Leitfähigkeit von 13 · 10⁶ S/m auf. Verglichen mit der Leitfähigkeit von 67,1 · 10⁶ S/m für kompaktes Silber entspricht dieses 21% des Maximalwertes. Nach dem Klebefilm-Test waren noch 96,4% der ursprünglichen Fläche durch die Silberstrukturen auf dem Substrat bedeckt.

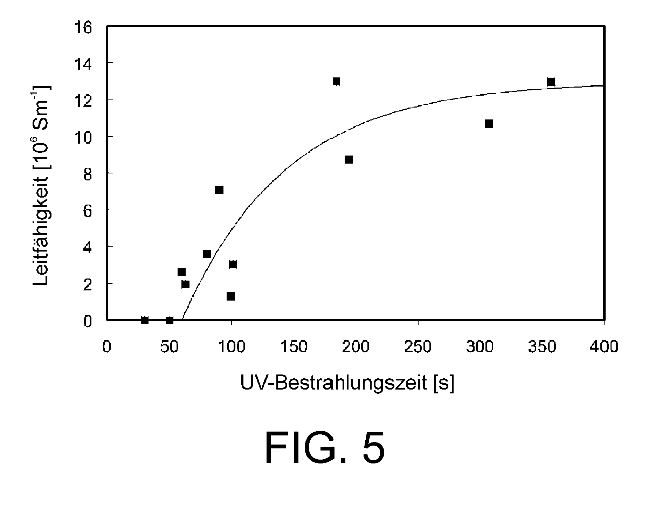

In einer Testreihe wurde weiterhin die Abhängigkeit der Leitfähigkeit der gemäß Beispiel 5 erhältlichen Silberstrukturen auf dem PET-Substrat von der Dauer der Bestrahlung mit UV-Licht bei gleichzeitigem Erwärmen auf 135 °C untersucht. Die Ergebnisse sind in FIG. 5 wiedergegeben. Nach einer Bestrahlungszeit von 60 Minuten wurde eine Leitfähigkeit von 2,6 · 10⁶ S/m erreicht, nach 180 Minuten die Sättigungsleitfähigkeit von 13 · 10⁶ S/m. Hierbei zeigt sich die synergistische Wirkung der UV-Bestrahlung und des Erwärmens, welche die Zersetzung des Silbercarboxylats (II) zum metallischen Silber erleichtert. Nach dem Erreichen einer Anfangsleitfähigkeit verlangsamt sich der Anstieg der Leitfähigkeit, bis ein Sättigungswert erreicht wird.

## Patentansprüche

1. Verfahren zur Herstellung von elektrisch leitfähigen Strukturen, **dadurch gekennzeichnet, dass** eine Lösung eines Metallcarboxylats der allgemeinen Formel (I)
[ Mⁿ⁺ ] [ ⁻OOC-CR¹R²-(O-CR³R⁴-CR⁵R⁶)_{z}-O-CR⁷R⁸-CR⁹R¹⁰-X-R¹² ]ₙ (I)
mit: M = Cu, Ag, Au, Ni, Pd oder Pt
n = 1, 2 oder 3
R¹, R² = unabhängig voneinander H, Halogen, Alkyl oder Aryl
R³, R⁴, R⁵, R⁶, R⁷, R⁸, R⁹, R¹⁰ = unabhängig voneinander H, Methyl, F oder Trifluormethyl
z = 1, 2, 3, 4, 5, 6, 7, 8, 9, 10, 11 oder 12
X = O, S oder NR¹¹ mit R¹¹ = Alkyl, substituiertes Alkyl, Aryl oder substituiertes Aryl
R¹² = unfluoriertes, teilfluoriertes oder perfluoriertes Alkyl oder Aryl
in einem koordinierendem Lösungsmittel mittels Tintenstrahldrucken auf ein Substrat aufgetragen wird und mittels Energieeinwirkung das aufgetragene Metallcarboxylat (I) zumindest teilweise in das entsprechende Metall M überführt wird.

2. Verfahren gemäß Anspruch 1, wobei das Metallcarboxylat (I) so ausgewählt ist, dass gilt: M = Ag; n = 1; R¹, R², R³, R⁴, R⁵, R⁶, R⁷, R⁸, R⁹, R¹⁰ = H; z = 1; X = O; R¹² = Methyl.

3. Verfahren gemäß Anspruch 1, wobei die Konzentration des Metallcarboxylats (I) in dem koordinierenden Lösungsmittel ≥ 1 Gewichts-% bis ≤ 30 Gewichts-% beträgt.

4. Verfahren gemäß Anspruch 1, wobei die Viskosität der Lösung des Metallcarboxylats (I) ≥ 1 mPa s bis ≤ 100 mPa s beträgt.

5. Verfahren gemäß Anspruch 1, wobei die Oberflächenspannung der Lösung des Metallcarboxylats (I) ≥ 20 mN/m bis ≤ 70 mN/m beträgt.

6. Verfahren gemäß Anspruch 1, wobei das koordinierende Lösungsmittel ausgewählt ist aus der Gruppe umfassend Wasser, Ethanol, Acetonitril, Tetrahydrofuran, Dioxan, Dimethylsulfoxid, aromatische Amine, Monoalkylamine, Dialkylamine, Trialkylamine, Monoalkanolamine, Dialkanolamine und/oder Trialkanolamine.

7. Verfahren gemäß Anspruch 1, wobei beim Tintenstrahldrucken die Tropfenbildung in einem piezoelektrisch angetriebenen Druckkopf erreicht wird.

8. Verfahren gemäß Anspruch 7, wobei der piezoelektrisch angetriebene Druckkopf mit einer Ansteuerspannung von ≥ 1 V bis ≤ 40 V und einer Pulsbreite von ≥ 1 µs bis ≤ 20 µs betrieben wird.

9. Verfahren gemäß Anspruch 1, wobei das Substrat ein Material umfasst, welches ausgewählt ist aus der Gruppe umfassend Glas, Polyimid, Polycarbonat und/oder Polyethylenterephthalat.

10. Verfahren gemäß Anspruch 1, wobei die Energieeinwirkung ein Erhitzen auf ≥ 200 °C bis ≤ 250 °C beinhaltet.

11. Verfahren gemäß Anspruch 1, wobei die Energieeinwirkung ein Bestrahlen mit Licht mit einer Wellenlänge von ≥ 325 nm bis ≤ 600 nm beinhaltet.

12. Verfahren gemäß Anspruch 11, wobei zusätzlich zum Bestrahlen mit Licht weiterhin eine Energieeinwirkung durch Erhitzen auf eine Temperatur von ≥ 100 °C bis ≤ 200 °C stattfindet.

13. Verfahren gemäß Anspruch 1, wobei das Tintenstrahldrucken so durchgeführt wird, dass der Abstand der Tropfen auf dem Substrat in einem Bereich von ≥ 15 µm bis ≤ 25 µm liegt und wobei mindestens 2 Tropfenreihen nebeneinander gedruckt werden.

14. Elektrisch leitfähige Strukturen, erhalten durch ein Verfahren gemäß Anspruch 1.

15. Verwendung einer Lösung eines Metallcarboxylats der allgemeinen Formel (I)
[Mⁿ⁺] [ ⁻OOC-CR¹R²-(O-CR³R⁴-CR⁵R⁶)_{z}-O-CR⁷R⁸-CR⁹R¹⁰-X-R¹² ]ₙ (I)
mit: M = Cu, Ag, Au, Ni, Pd oder Pt
n = 1, 2 oder 3
R¹, R² = unabhängig voneinander H, Halogen, Alkyl oder Aryl
R³, R⁴, R⁵, R⁶, R⁷, R⁸, R⁹, R¹⁰ = unabhängig voneinander H, Methyl, F oder Trifluormethyl
z = 1, 2, 3, 4, 5, 6, 7, 8, 9, 10, 11 oder 12
X = O, S oder NR¹¹ mit R¹¹ = Alkyl, substituiertes Alkyl, Aryl oder substituiertes Aryl
R¹² = unfluoriertes, teilfluoriertes oder perfluoriertes Alkyl oder Aryl
in einem koordinierendem Lösungsmittel als Tinte für Tintenstrahldrucker.
